# EUROPEAN PATENT APPLICATION

(11) **EP 4 621 582 A1**
(43) Date of publication of application: **24.09.2025**
(21) Application number: 25165291.3
(22) Date of filing: 21.03.2025
(51) Int. Cl.: G06F 13/16, G06F 13/42, G11C 5/02

(54) **SYSTEM AND METHOD FOR MODULAR HBM CHIPLET ARCHITECTURE**

(30) Priority: 22.03.2024 US 202463568835 P; 20.03.2025 US 202519085669
(71) Applicant: Samsung Electronics Co., Ltd., Suwon-si, Gyeonggi-do 16677 (KR)
(72) Inventor: YAO, Chih-Wei, San Jose, CA, 95134 (US); YANG, Li, Austin, TX, 78745 (US); QUACH, Nhon, San Jose, CA, 95134 (US)
(74) Representative: Kuhnen & Wacker Patent- und Rechtsanwaltsbüro PartG mbB

(57) **Abstract**

A modular high-bandwidth memory (HBM) system and method are disclosed. The system includes a compute die including a memory controller, one or more die-to-die (D2D) channels coupled to the compute die; and one or more HBM chiplets coupled to the one or more D2D channels. The one or more chiplets are configured to receive a memory access request, and process the memory access request or forward the memory access request to a subsequent HBM chiplet.

## Description

### TECHNICAL AREA

The present disclosure relates generally to high-bandwidth memory (HBM) architectures, and more particularly, to modular HBM chiplets that utilize daisy-chain and network-grid configurations to provide scalable memory bandwidth and capacity.

### BACKGROUND

HBM architectures are commonly used in artificial intelligence (AI) accelerators and high-performance computing systems to provide fast data access. An AI accelerator system-in-package (SiP) may include a compute die and one or more HBM dies, which communicate through high-speed die-to-die (D2D) interconnects that transfer read and write commands along with data traffic. The efficiency of these interconnects may determine overall system performance. Existing HBM architectures, however, face limitations that hinder scalability and bandwidth expansion.

AI accelerators are constrained by the memory wall, where the performance of the compute die is limited by the rate at which data can be supplied by HBM. While compute dies are fabricated using advanced processing technologies capable of handling high-bandwidth data, existing HBM interfaces may not deliver data quickly enough to fully utilize the computational capability of the accelerator. This discrepancy results in a bottleneck that restricts the overall efficiency of workloads that require continuous, high-speed memory access.

Traditional HBM configurations may rely on point-to-point connections between the compute die and memory modules. In this configuration, however, the number of HBM dies that can be connected may be limited by the shoreline width of the compute die and the number of available routing layers in semiconductor packaging technologies (e.g., 2.5D packaging). These physical constraints can prevent AI accelerators from scaling their memory resources in a flexible manner. Additionally, stacking more dynamic read only memory (DRAM) dies within an HBM module can be challenging due to packaging limitations, making it difficult to increase memory bandwidth through conventional means.

To address these challenges, increasing memory bandwidth may require an architectural shift that allows for more efficient memory expansion.

### SUMMARY

To address the aforementioned issues, the present disclosure introduces a modular HBM design that enables scalable memory bandwidth through the interconnection of multiple HBM chiplets. These HBM chiplets can be arranged in a daisy-chain configuration, where later nodes in the chain receive traffic passed through earlier nodes, or in a network-grid configuration (a mesh network configuration), where data traffic is dynamically routed through an interconnected memory network. These configurations allow memory capacity and bandwidth to scale beyond the limitations of traditional HBM architectures.

By implementing a modular and scalable memory architecture, AI accelerators can adapt to varying workload demands. A low-end system may operate with a single HBM chiplet, while high-end configurations can integrate multiple interconnected chiplets to achieve higher bandwidth. This approach provides a flexible and efficient solution for overcoming the memory wall, and ensuring that AI accelerators can fully leverage their computational capabilities without being constrained by memory bandwidth limitations.

According to an embodiment, a modular HBM system includes a compute die including a memory controller, one or more D2D channels coupled to the compute die; and one or more HBM chiplets coupled to the one or more D2D channels. The one or more chiplets are configured to receive a memory access request, and process the memory access request or forward the memory access request to a subsequent HBM chiplet.

According to an embodiment, a method includes transmitting, by a compute die, a memory access request via one or more D2D channels to one or more HBM chiplets; and receiving, by the one or more HBM chiplets, the memory access request, wherein the one or more HBM chiplets are configured to process the memory access request or forward the memory access request to a subsequent HBM chiplet.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 illustrates a first version of a daisy-chain HBM chiplet package, according to an embodiment;
FIG. 2 illustrates a second version of a daisy-chain HBM chiplet package, according to an embodiment;
FIG. 3 illustrates a third version of a daisy-chain HBM chiplet package, according to an embodiment;
FIG. 4 is a daisy-chain memory access architecture utilizing a D2D channel with preassigned address spaces, according to an embodiment;
FIG. 5 illustrates a version of a network-grid HBM chiplet package, according to an embodiment; and
FIG. 6 is a flowchart illustrating a method for managing memory in a computing system using modular HBM chiplet architecture, according to an embodiment.

### DETAILED DESCRIPTION

Hereinafter, embodiments of the present disclosure are described in detail with reference to the accompanying drawings. It should be noted that the same elements will be designated by the same reference numerals although they are shown in different drawings. In the following description, specific details such as detailed configurations and components are merely provided to assist with the overall understanding of the embodiments of the present disclosure. Therefore, it should be apparent to those skilled in the art that various changes and modifications of the embodiments described herein may be made without departing from the scope of the present disclosure. In addition, descriptions of well-known functions and constructions are omitted for clarity and conciseness. The terms described below are terms defined in consideration of the functions in the present disclosure, and may be different according to users, intentions of the users, or customs. Therefore, the definitions of the terms should be determined based on the contents throughout this specification.

The present disclosure may have various modifications and various embodiments, among which embodiments are described below in detail with reference to the accompanying drawings. However, it should be understood that the present disclosure is not limited to the embodiments, but includes all modifications, equivalents, and alternatives within the scope of the present disclosure.

Although the terms including an ordinal number such as first, second, etc. may be used for describing various elements, the structural elements are not restricted by the terms. The terms are only used to distinguish one element from another element. For example, without departing from the scope of the present disclosure, a first structural element may be referred to as a second structural element. Similarly, the second structural element may also be referred to as the first structural element. As used herein, the term "and/or" includes any and all combinations of one or more associated items.

The terms used herein are merely used to describe various embodiments of the present disclosure but are not intended to limit the present disclosure. Singular forms are intended to include plural forms unless the context clearly indicates otherwise. In the present disclosure, it should be understood that the terms "include" or "have" indicate existence of a feature, a number, a step, an operation, a structural element, parts, or a combination thereof, and do not exclude the existence or probability of the addition of one or more other features, numerals, steps, operations, structural elements, parts, or combinations thereof.

Unless defined differently, all terms used herein have the same meanings as those understood by a person skilled in the art to which the present disclosure belongs. Terms such as those defined in a generally used dictionary are to be interpreted to have the same meanings as the contextual meanings in the relevant field of art, and are not to be interpreted to have ideal or excessively formal meanings unless clearly defined in the present disclosure.

In HBM architectures, an AI accelerator (for example, a specialized processor such as a graphics processing unit (GPU), neural processing unit (NPU), or custom machine learning (ML) chip) may utilize multiple HBM dies, each of which may be a stacked dynamic read only memory (DRAM)-based memory structure that uses advanced packaging (for instance, 2.5D or 3D integration) for high data throughput. Since HBM technology may be a specialized subset of DRAM arranged in a dense, vertical layout, these HBM dies may communicate efficiently with a compute die (the integrated circuit containing the main processing or control logic) through high-speed interfaces (for example, 2D2 interconnects or high-density interposer links).

Some implementations of GBM architectures, including HBM1, HBM 2, and HBM3, as well as the upcoming HBM4, rely on point-to-point high-speed I/O (HSIO) connections between the compute die and each HBM module. These direct connections facilitate high-speed data transfer but often impose limitations on the number of HBM modules that can be integrated into a system.

The maximum number of HBM modules that an AI accelerator can accommodate often depends on the "shoreline width" of the compute die, which refers to the available edge perimeter where physical interfaces can be placed. Because each HBM module needs a dedicated interface along this perimeter, the overall physical dimensions of the compute die directly affect how many memory attachments can be used. As the number of HBM modules grows, each one also requires individual routing lanes and interface logic, which further constrains scalability.

In addition to shoreline constraints, HBM module width may also affect determining memory capacity and layout efficiency. Some HBM modules have a standard width of 10.5 millimeters (mm), which affects the overall packaging density and interconnect routing within an SiP, which may be defined as an advanced packaging arrangement in which the compute die and one or more HBM chiplets are integrated together within a single package. An HBM "chiplet" may refer to a modular memory component composed of stacked DRAM dies. These limitations present challenges in scaling memory bandwidth to meet the increasing computational demands of AI workloads.

As mentioned above, the ability to stack multiple DRAM dies within an HBM module is constrained by packaging technology. While vertical stacking improves memory density, it may be limited by factors such as thermal dissipation, manufacturing complexity, and signal integrity. These constraints can limit the number of DRAM dies that can be effectively integrated into a single HBM stack, restricting the overall memory capacity and bandwidth available to AI accelerators.

For high-end AI accelerators, maximizing memory bandwidth may be prioritized to ensure that computational resources are not bottlenecked by data availability. These accelerators may require a relatively high possible memory bandwidth to prevent performance degradation caused by the memory wall.

For mid-end AI accelerators, memory and bandwidth requirements may be more modest. These systems may not always require large amounts of memory, and excessive bandwidth could result in unnecessary power consumption and cost. To accommodate both high-end and mid-end AI accelerators efficiently, the present disclosure proposes implementing a modular and scalable HBM chiplet architecture that allows memory capacity and bandwidth to be adjusted based on the specific needs of the system.

According to an embodiment, a modular HBM chiplet architecture may be implemented using a daisy-chain configuration to enable scalable memory expansion. In this configuration, multiple HBM chiplets may be connected in sequence, with each HBM chiplet acting as a node in the chain. The HBM chiplets may each be similar to one another (e.g., having the same memory capacity, size, and/or interface protocols) to function interchangeably within the daisy-chain configuration, or may have different properties from one another. The traffic for later nodes in the daisy-chain may pass through earlier nodes, allowing for efficient memory communication without requiring additional direct connections to the compute die. This architecture can enable AI accelerators to expand memory bandwidth according to system requirements while maintaining a modular and uniform HBM chiplet design.

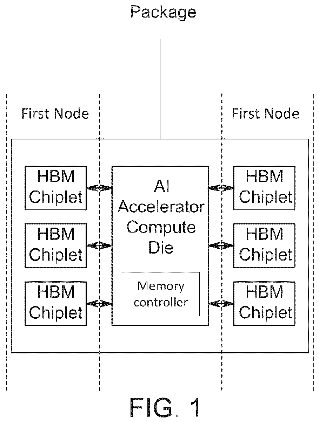

FIG. 1 illustrates a first version of a daisy-chain HBM chiplet package, according to an embodiment.

Referring to FIG. 1, the HBM chiplet package may be a mid-end AI accelerator with one node in the daisy-chain. Because there is only one node, traffic is not forwarded to subsequent chiplets.

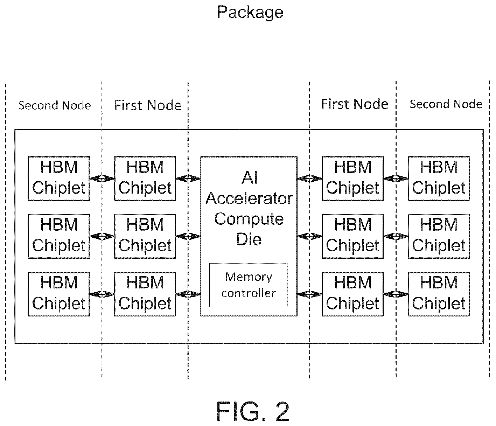

FIG. 2 illustrates a second version of a daisy-chain HBM chiplet package, according to an embodiment.

Referring to FIG. 2, the HBM chiplet package may be a high-end AI accelerator with two nodes in the daisy-chain, effectively doubling the memory capacity and bandwidth.

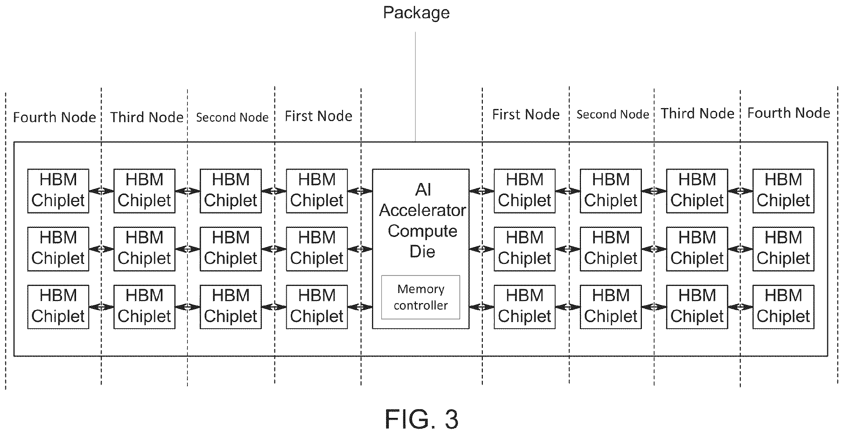

FIG. 3 illustrates a third version of a daisy-chain HBM chiplet package, according to an embodiment.

Referring to FIG. 3, the HBM chiplet package may be an ultra high-end AI accelerator that further expands the number of nodes to four nodes in the daisy-chain, which may quadruple the memory capacity and bandwidth. Although four nodes our shown, additional nodes may be included to further increase memory capacity and bandwidth.

A daisy-chain node configuration discovery process will now be described.

A low-speed command and register read/write protocol may allow the compute die to discover and configure the number of HBM chiplets in the daisy-chain. Each command may include a node ID (NN) that indicates the distance of a node from the compute die.

In a one-node daisy-chain discovery process, as illustrated in FIG. 1, the compute die may issue a discovery command with NN=1 to access the first node. The first node may decrement the node ID by 1, resulting in NN=0. When NN=0, the command may be determined to be intended for the local HBM chiplet, and no further forwarding should occur. If the compute die does not know the total number of nodes in the daisy chain, it may issue a command with NN=2, for example, expecting to reach the second node. In this case, the first node may decrement NN to 1 and forward the command. Since there is no second node in FIG. 1, an error may be reported to the compute die in this case, indicating that the chain includes a single node.

In a two-node daisy-chain discovery process, as illustrated in FIG. 2, the compute die may issue a command with NN=2. The first node may decrement NN to 1 and forward the request to the second node. The second node may decrement NN to 0, process the request, and respond to the compute die. If the compute die attempts to discover a third node by issuing NN=3, the second node may forward the request to the third position, where no HBM chiplet exists, triggering an HBM chiplet in the second node position to transmit an error message that is returned to the compute die.

For configurations with more than two nodes, as illustrated in FIG. 3, a similar discovery method may apply. The compute die may continue issuing commands with increasing NN values to probe for additional nodes. Each HBM chiplet may decrement the NN value and forward the command until the final node is reached or an error message is returned.

Once the compute die has discovered the number of nodes in the daisy chain, firmware can be uploaded to each node. Each node can have different firmware or register configurations, provided that the correct node ID is specified during initialization.

Access methods of HBM chiplets in the daisy-chain configuration will now be described.

A memory controller in the compute die, as shown in FIGS. 1-3 and 5, may distribute memory read and write requests across multiple D2D channels, where each channel is mapped to a specific range of memory addresses. Each HBM chiplet may include a relay block that decodes incoming memory requests. If the requested memory address falls within the local HBM chiplet's assigned range, the request may be processed locally at the HBM chiplet for the given node. When a request is processed locally, the HBM chiplet may read from or write to its memory to process a command. Otherwise (if the requested memory address does not fall within the local HBM chiplet's assigned range), the HBM chiplet may forward the request to the HBM chiplet at the next node in the daisy-chain.

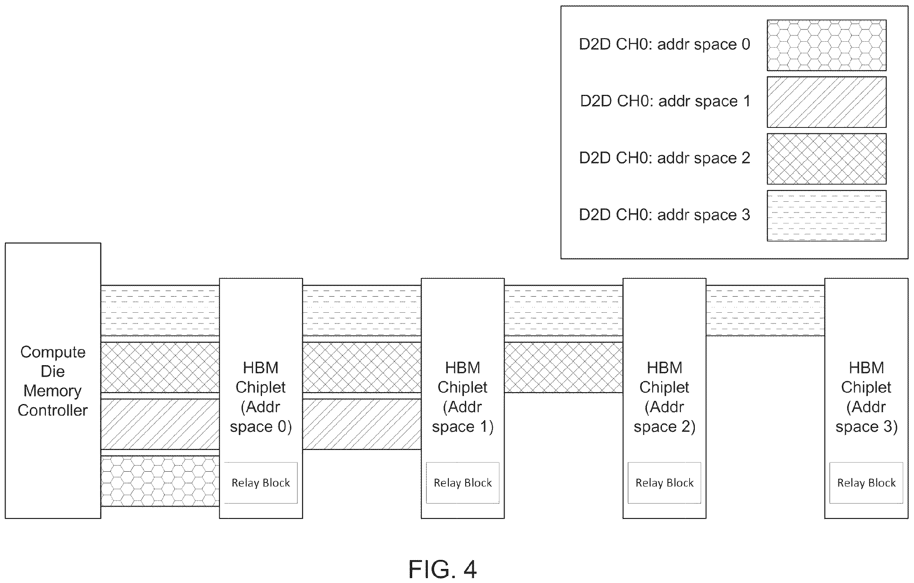

FIG. 4 is a daisy-chain memory access architecture utilizing a D2D channel with preassigned address spaces, according to an embodiment.

As illustrated in FIG. 4, a D2D channel is assigned to distinct address spaces. Each memory request may follow a predefined routing path to ensure that it reaches the correct HBM chiplet. The compute die's memory controller may issue commands to specific address spaces in the D2D channel, ensuring that each request is directed toward the appropriate address range. If an HBM chiplet receives a request for an address outside its range, its relay block may automatically forward it to the next HBM chiplet in the sequence until it reaches an HBM chiplet at the correct node.

Accordingly, by implementing a daisy-chain configuration, AI accelerators can dynamically scale memory bandwidth and capacity while minimizing the need for additional compute die interfaces.

According to an embodiment, a modular HBM architecture may be implemented using a network-grid configuration to enable scalable memory expansion. In this configuration, multiple HBM chiplets may be interconnected in a grid-like structure, where each HBM chiplet acts as a network node capable of forwarding memory requests to the appropriate destination. Unlike the daisy-chain approach, where traffic is constrained to a linear path, the network grid allows any D2D port to access any memory address.

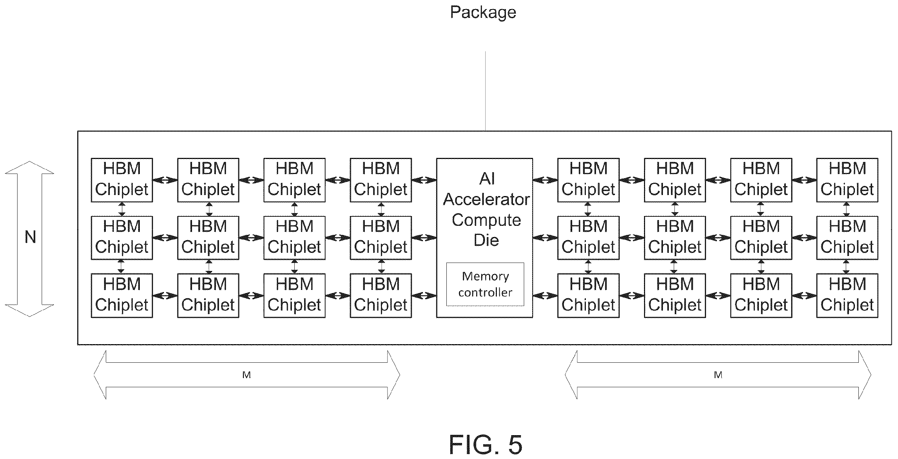

FIG. 5 illustrates a version of a network-grid HBM chiplet package, according to an embodiment.

Referring to FIG. 5, the network-grid configuration includes an AI accelerator compute die interfacing with multiple HBM chiplets arranged in a structured N×M grid. Each HBM chiplet is connected to two or more adjacent HBM chiplets, allowing for flexible and multiple routing paths. This architecture may ensure that memory access requests can be dynamically routed through the network to reach their intended destination.

Each HBM chiplet in the network grid may serve as a forwarding node so that a memory command does not have to travel through a strict sequential path. Instead, the system can determine the most efficient route for each request. If one path becomes congested or unavailable, data can be rerouted through alternate paths, enhancing fault tolerance and load balancing. Additionally, the grid structure may reduce the dependency on a single critical interconnect to improve overall reliability.

Additionally, the network grid configuration may integrate compute-in-memory (CIM) capabilities into each HBM chiplet. In this scenario, each HBM chiplet may include a mini compute die, allowing for localized data processing before transferring information back to the AI accelerator. By offloading certain computations to memory nodes, CIM architectures can reduce data movement overhead.

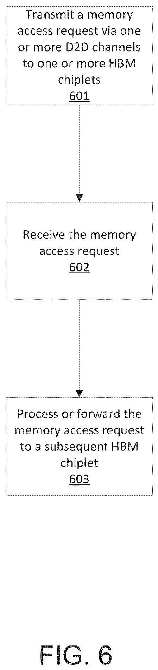

FIG. 6 is a flowchart illustrating a method for managing memory in a computing system using modular HBM chiplet architecture, according to an embodiment.

The method illustrated in FIG. 6 may be performed by one or more processing elements within a computing system, including but not limited to a compute die, a memory controller, an HBM chiplet, or any combination thereof. The method may be implemented in hardware, software, firmware, or any combination of these, and may be executed by dedicated circuitry, programmable logic, or one or more processors configured to perform memory management operations. The method may be stored as instructions on a non-transitory computer-readable medium, and when executed, may facilitate memory access, data transfer, and request routing between interconnected memory components in a modular HBM architecture.

Referring to FIG. 6, in step 601, the compute die transmits a memory access request via one or more D2D channels to one or more HBM chiplets. The memory access request may include a read command, a write command, or a control command specifying a particular memory address range. The compute die may distribute such requests across multiple D2D channels based on an address mapping scheme or a memory interleaving policy to optimize bandwidth utilization. In some embodiments, the memory access request may also include metadata, such as a priority level, error correction codes, or routing information, to facilitate efficient processing by the receiving HBM chiplet.

In step 602, the one or more HBM chiplets receive the memory access request. Each HBM chiplet may include a relay block or routing logic to decode the request and determine whether it corresponds to a local memory address or needs to be forwarded. The chiplet may verify the integrity of the request using built-in error detection mechanisms, such as CRC or parity bits. The request may be stored in an internal buffer or queue for processing, and the chiplet may generate an acknowledgment signal to the compute die confirming receipt of the request. In some embodiments, the chiplet may also initiate prefetching operations to anticipate future memory requests and improve overall access latency.

In step 603, the one or more HBM chiplets are configured to process the memory access request or forward the memory access request to a subsequent HBM chiplet. If the requested memory address falls within the chiplet's assigned address range, the chiplet may access its internal DRAM and retrieve or update the corresponding data. If the address is outside the local range, the chiplet may forward the request to a subsequent chiplet using an interconnect mechanism based on a daisy-chain or network-grid topology. In some configurations, the chiplet may dynamically determine the most efficient forwarding path based on network congestion, power efficiency considerations, or load-balancing strategies. The chiplet may also perform CIM operations before returning data to the compute die.

Embodiments of the subject matter and the operations described in this specification may be implemented in digital electronic circuitry, or in computer software, firmware, or hardware, including the structures disclosed in this specification and their structural equivalents, or in combinations of one or more of them. Embodiments of the subject matter described in this specification may be implemented as one or more computer programs, i.e., one or more modules of computer-program instructions, encoded on computer-storage medium for execution by, or to control the operation of data-processing apparatus. Additionally or alternatively, the program instructions can be encoded on an artificially-generated propagated signal, e.g., a machine-generated electrical, optical, or electromagnetic signal, which is generated to encode information for transmission to suitable receiver apparatus for execution by a data processing apparatus. A computer-storage medium can be, or be included in, a computer-readable storage device, a computer-readable storage substrate, a random or serial-access memory array or device, or a combination thereof. Moreover, while a computer-storage medium is not a propagated signal, a computer-storage medium may be a source or destination of computer-program instructions encoded in an artificially-generated propagated signal. The computer-storage medium can also be, or be included in, one or more separate physical components or media (e.g., multiple compact disks (CDs), disks, or other storage devices). Additionally, the operations described in this specification may be implemented as operations performed by a data-processing apparatus on data stored on one or more computer-readable storage devices or received from other sources.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A modular high-bandwidth memory (HBM) system, comprising:
a compute die including a memory controller;
one or more die-to-die (D2D) channels coupled to the compute die; and
one or more HBM chiplets coupled to the one or more D2D channels and configured to:
receive a memory access request, and
process the memory access request or forward the memory access request to a subsequent HBM chiplet.

2. The modular HBM system of Claim 1, wherein the one or more HBM chiplets are configured to:
process the memory access request in case the memory access request corresponds to a local memory address range.

3. The modular HBM system of Claim 1, wherein the one or more HBM chiplets are configured to:
forward the memory access request to the subsequent HBM chiplet in case the memory access request does not correspond to a local memory address range.

4. The modular HBM system of Claim 1, wherein the one or more HBM chiplets are connected in a daisy-chain configuration.

5. The modular HBM system of Claim 4, wherein the memory controller in the compute die is configured to determine a number of nodes connected in the daisy-chain configuration by issuing a discovery command with a node number that is decremented by each of the one or more HBM chiplets connected in the daisy-chain configuration.

6. The modular HBM system of Claim 5, wherein in a case in which the node number of the discovery command is equal to 0, the discovery command is processed locally.

7. The modular HBM system of Claim 5, wherein in a case in which the node number of the discovery command is greater than 0, the discovery command is forwarded to a subsequent HBM chiplet in the daisy-chain configuration.

8. The modular HBM system of Claim 5, wherein in a case in which the node number of the discovery command is an invalid value, an error message is transmitted to the compute die, enabling the compute die to determine the total number of nodes in the daisy-chain configuration.

9. The modular HBM system of Claim 1, wherein the one or more HBM chiplets are connected in a network-grid configuration, and
wherein each of the one or more HBM chiplets connected in the network-grid configuration is configured to forward the memory access request along multiple routing paths.

10. The modular HBM system of Claim 9, wherein the one or more HBM chiplets connected in the network-grid configuration include a built-in compute die configured to perform a compute-in-memory (CIM) operation.

11. A method comprising:
transmitting, by a compute die, a memory access request via one or more die-to-die (D2D) channels to one or more high-bandwidth memory (HBM) chiplets; and
receiving, by the one or more HBM chiplets, the memory access request,
wherein the one or more HBM chiplets are configured to process the memory access request or forward the memory access request to a subsequent HBM chiplet.

12. The method of Claim 11, further comprising:
processing the memory access request at the one or more HBM chiplets in response to determining that the memory access request corresponds to a local memory address range.

13. The method of Claim 11, further comprising:
forwarding the memory access request from the one or more HBM chiplets to the subsequent HBM chiplet in response to determining that the memory access request does not correspond to a local memory address range.

14. The method of Claim 11, wherein the one or more HBM chiplets are connected in a daisy-chain configuration.

15. The method of Claim 14, further comprising:
determining, by a memory controller in the compute die, a number of nodes connected in the daisy-chain configuration by issuing a discovery command with a node number that is decremented by each of the one or more HBM chiplets connected in the daisy-chain configuration.

16. The method of Claim 15, wherein in a case in which the node number of the discovery command is equal to 0, the discovery command is processed locally.

17. The method of Claim 15, wherein in a case in which the node number of the discovery command is greater than 0, the discovery command is forwarded to a subsequent HBM chiplet in the daisy-chain configuration.

18. The method of Claim 15, wherein in a case in which the node number of the discovery command is an invalid value, an error message is transmitted to the compute die, enabling the compute die to determine the total number of nodes in the daisy-chain configuration.

19. The method of Claim 11, wherein the one or more HBM chiplets are connected in a network-grid configuration, and
wherein each of the one or more HBM chiplets connected in the network-grid configuration is configured to forward the memory access request along multiple routing paths.

20. The method of Claim 19, wherein the one or more HBM chiplets connected in the network-grid configuration include a built-in compute die configured to perform a compute-in-memory (CIM) operation.
